# EUROPEAN PATENT APPLICATION

(11) **EP 4 841 894 A2**
(43) Date of publication of application: **18.11.2026**
(21) Application number: 26153663.5
(22) Date of filing: 23.01.2026
(51) Int. Cl.: H03K 5/156

(54) **DUTY CYCLE CORRECTION CIRCUIT**

(30) Priority: 13.05.2025 KR 20250061850
(71) Applicant: SK hynix Inc., Bubal-eub Icheon-si Gyeonggi-do 17336 (KR)
(72) Inventor: LEE, Ji Young, 17336 Icheon-si, Gyeonggi-do (KR); KWON, Do Hyeon, 17336 Icheon-si, Gyeonggi-do (KR); KIM, Heon Ki, 17336 Icheon-si, Gyeonggi-do (KR); RYU, Chan Yang, 17336 Icheon-si, Gyeonggi-do (KR); PARK, Ji Hyeon, 17336 Icheon-si, Gyeonggi-do (KR); OK, Sung Hwa, 17336 Icheon-si, Gyeonggi-do (KR); CHOI, Eun Ji, 17336 Icheon-si, Gyeonggi-do (KR)
(74) Representative: Isarpatent

(57) **Abstract**

A duty cycle correction circuit includes a duty adjustment circuit, a phase dividing circuit, and a duty detection circuit. The duty adjustment circuit adjusts a phase of each of a plurality of external clock signals according to a plurality of duty control codes to generate a plurality of duty correction clock signals. The phase dividing circuit divides phases of the plurality of duty correction clock signals to generate a plurality of multiphase clock signals. The duty detection circuit, during an offset adjustment interval, adjusts an offset decision bit among a plurality of offset control codes and determines whether offset compensation is performed based on a phase difference between the plurality of multiphase clock signals, and when the offset compensation is performed, adjusts offset adjustment bits among the plurality of offset control codes.

## Description

### BACKGROUND

### 1. TECHNICAL FIELD

The present disclosure generally relates to a semiconductor circuit, including but not limited to a duty cycle correction circuit.

### 2. RELATED ART

In a semiconductor circuit that operates based on a clock signal, such as a semiconductor memory or a central processing unit (CPU) or a graphics processing unit (GPU) that controls the semiconductor memory, precise control of the duty of the clock signal is important. For example, in a semiconductor memory in which data is input and output at a rising edge and a falling edge of the clock signal, when the duty of the clock signal is not exactly 50%, the timing between the rising edge and the falling edge is misaligned and data might not be input and output with correct timing. For reference, the duty of the clock signal at 50% indicates that a duration of a high-level interval is equal to a duration of a low-level interval of the clock signal. Therefore, in various semiconductor circuits that operate based on a clock signal, a duty cycle correction circuit that compensates for the duty of the clock signal is used.

### SUMMARY

In an embodiment, a duty cycle correction circuit may include a duty adjustment circuit, a phase dividing circuit, and a duty detection circuit. The duty adjustment circuit may be configured to adjust a phase of each of a plurality of external clock signals according to a plurality of duty control codes to generate a plurality of duty correction clock signals. The phase dividing circuit may be configured to divide phases of the plurality of duty correction clock signals to generate a plurality of multiphase clock signals. The duty detection circuit may be configured to, during offset adjustment interval, adjust an offset decision bit among a plurality of offset control codes and determine whether offset compensation is performed based on a phase difference between the plurality of multiphase clock signals, and when the offset compensation is performed, may be configured to adjust offset adjustment bits among the plurality of offset control codes.

In an embodiment, a duty cycle correction circuit may include a duty adjustment circuit, a phase dividing circuit, and a duty detection circuit. The duty adjustment circuit may be configured to adjust a phase of each of a plurality of external clock signals according to a plurality of duty control codes to generate a plurality of duty correction clock signals. The phase dividing circuit may be configured to divide phases of the plurality of duty correction clock signals to generate a plurality of multiphase clock signals. The duty detection circuit may be configured to generate a plurality of offset adjustment reference signals having a target duty cycle regardless of a duty cycle of the multiphase clock signals by using the plurality of multiphase clock signals, may be configured to, during an offset adjustment interval, adjust an offset decision bit among a plurality of offset control codes and determine whether offset compensation is performed based on a phase difference between the plurality of offset adjustment reference signals, and when the offset compensation is performed, may adjust offset adjustment bits among the plurality of offset control codes.

In an embodiment, a duty cycle correction circuit may include a duty detection circuit and a duty control circuit. The duty detection circuit may be configured to detect a phase difference between a plurality of multiphase clock signals according to a plurality of control signals including a first offset control code and a second offset control code and to generate a first duty detection signal and a second duty detection signal. The duty control circuit may be configured to generate the plurality of control signals according to the first duty detection signal and the second duty detection signal. The duty detection circuit may include an offset compensation circuit configured to apply a first capacitance to a first output terminal outputting the first duty detection signal according to a first offset decision bit of the first offset control code, apply a second capacitance to the first output terminal according to first offset adjustment bits of the first offset control code, apply a third capacitance to a second output terminal outputting the second duty detection signal according to a second offset decision bit of the second offset control code, and apply a fourth capacitance to the second output terminal according to second offset adjustment bits of the second offset control code. The duty control circuit may be configured to, during an offset adjustment interval, determine whether offset compensation is performed by comparing a value of the first duty detection signal obtained by adjusting the first offset control code by 0.5 step and a value of the first duty detection signal obtained by adjusting the second offset control code by 0.5 step, and the offset compensation is performed, may be perform a process including adjusting one of the first offset control code and the second offset control code by 1 step to compensate for an offset.

### BRIEF DESCRIPTION OF THE DRAWINGS

FIG. 1 is a diagram illustrating a configuration of a duty cycle correction circuit according to an embodiment of the present disclosure.
FIG. 2 is a diagram illustrating a configuration of a first adjustment circuit according to an embodiment of the present disclosure.
FIG. 3 is a diagram illustrating a configuration of a second adjustment circuit according to an embodiment of the present disclosure.
FIG. 4 is a diagram illustrating a configuration of a duty detection circuit according to an embodiment of the present disclosure.
FIG. 5 is a diagram illustrating a configuration of a phase mixing circuit according to an embodiment of the present disclosure.
FIG. 6 is a diagram illustrating a configuration of a duty voltage conversion circuit according to an embodiment of the present disclosure.
FIG. 7 is a diagram illustrating a configuration of an offset compensation circuit according to an embodiment of the present disclosure.
FIG. 8 is a flowchart illustrating an offset adjustment operation of a duty detection circuit according to an embodiment of the present disclosure.
FIG. 9 is a diagram illustrating a configuration of a duty cycle correction circuit according to an embodiment of the present disclosure.
FIG. 10 is a diagram illustrating a configuration of a duty detection circuit according to an embodiment of the present disclosure.
FIG. 11 is a diagram illustrating a configuration of an offset adjustment reference signal generation circuit according to an embodiment of the present disclosure.
FIG. 12A, FIG. 12B, FIG. 13A, and FIG. 13B are timing diagrams illustrating timing of duty detection operations according to an embodiment of the present disclosure.

### DETAILED DESCRIPTION

Various embodiments can improve duty cycle correction performance by enhancing offset correction performance of an input signal.

Embodiments of the present disclosure are described in detail with reference to the accompanying drawings. Specific structural or functional descriptions of embodiments are provided as examples to describe concepts that are disclosed in the present application. Examples or embodiments in accordance with the concepts may be carried out in various forms, and the scope of the present disclosure is not limited to the examples or embodiments described in this specification.

When one element is identified as "connected" or "coupled" to another element, the elements may be connected or coupled directly or through at least one intervening element between the elements. When two elements are identified as "directly connected" or "directly coupled," one element is directly connected or directly coupled to the other element without an intervening element between the two elements.

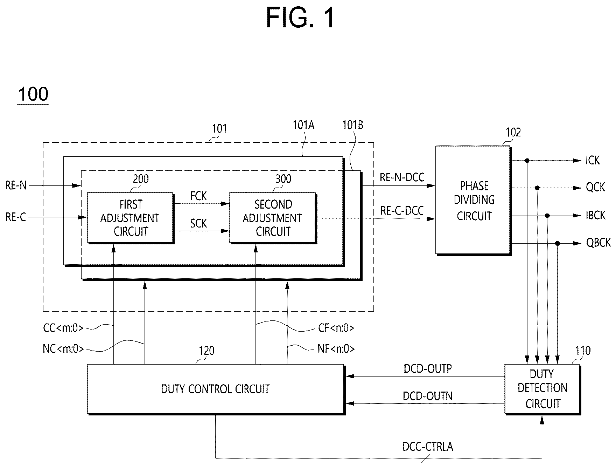

FIG. 1 is a diagram illustrating a configuration of a duty cycle correction circuit 100 according to an embodiment of the present disclosure.

Referring to FIG. 1, the duty cycle correction circuit 100 includes a duty adjustment circuit 101, a phase dividing circuit 102, a duty detection circuit 110, and a duty control circuit 120.

The duty adjustment circuit 101 receives a plurality of external clock signals RE-C and RE-N and a plurality of duty control codes CC<m:0>, CF<n:0>, NC<m:0>, and NF<n:0> and outputs a plurality of duty correction clock signals RE-C-DCC and RE-N-DCC. The duty adjustment circuit 101 includes a first duty adjustment circuit 101A and a second duty adjustment circuit 101B. The plurality of external clock signals RE-C and RE-N include a first external clock signal RE-C and a second external clock signal RE-N.

The plurality of duty control codes CC<m:0>,CF<n:0>, NC<m:0>, and NF<n:0> are divided into a first code set CC<m:0> and CF<n:0> related to phase correction of the first external clock signal RE-C and a second code set NC<m:0> and NF<n:0> related to phase correction of the second external clock signal RE-N and are selectively adjusted. Among the first code set CC<m:0> and CF<n:0>, CC<m:0> is referred to as a first code and CF<n:0> is referred to as a second code. Among the second code set NC<m:0> and NF<n:0>, NC<m:0> is referred to as a third code and NF<n:0> is referred to as a fourth code. During execution of a duty correction operation, one of the first code set CC<m:0>, CF<n:0> or the second code set NC<m:0>, NF<n:0> is selected and adjusted according to operating conditions.

The first code CC<m:0> and the second code CF<n:0> are used for phase adjustment of the first duty adjustment circuit 101A. The third code NC<m:0> and the fourth code NF<n:0> are used for phase adjustment of the second duty adjustment circuit 101B. The plurality of duty correction clock signals RE-C-DCC and RE-N-DCC include a first duty correction clock signal RE-C-DCC and a second duty correction clock signal RE-N-DCC.

The first duty adjustment circuit 101A receives the first external clock signal RE-C, the first code CC<m:0>, and the second code CF<n:0> and outputs the first duty correction clock signal RE-C-DCC. The second duty adjustment circuit 101B receives the second external clock signal RE-N, the third code NC<m:0>, and the fourth code NF<n:0> and outputs the second duty correction clock signal RE-N-DCC.

The first duty adjustment circuit 101A includes a first adjustment circuit 200 and a second adjustment circuit 300. The first adjustment circuit 200 delays the first external clock signal RE-C by a time corresponding to the first code CC<m:0> and generates a first clock signal FCK and a second clock signal SCK. The second adjustment circuit 300 mixes the first clock signal FCK and the second clock signal SCK at a predetermined ratio according to the second code CF<n:0> to generate the first duty correction clock signal RE-C-DCC. The word "predetermined" as used with respect to a parameter, such as a predetermined ratio, predetermined interval, predetermined combination, predetermined time, or predetermined logic level, indicates that a value for the parameter is determined prior to use of the parameter during a process or algorithm. The value for the parameter may be determined before the process or algorithm begins. The value for the parameter may be determined during the process or algorithm but before the parameter is used during the process or algorithm.

The second duty adjustment circuit 101B is configured similarly to the first duty adjustment circuit 101A.

The phase dividing circuit 102 receives the first duty correction clock signal RE-C-DCC and the second duty correction clock signal RE-N-DCC and outputs multiphase clock signals ICK, QCK, IBCK, and QBCK. The phase dividing circuit 102 divides phases of the first duty correction clock signal RE-C-DCC and the second duty correction clock signal RE-N-DCC to generate the multiphase clock signals ICK, QCK, IBCK, and QBCK. The multiphase clock signals ICK, QCK, IBCK, and QBCK include a first phase clock signal ICK, a second phase clock signal QCK, a third phase clock signal IBCK, and a fourth phase clock signal QBCK.

The duty detection circuit 110 receives a plurality of control signals DCC-CTRLA and the multiphase clock signals ICK, QCK, IBCK, and QBCK and outputs a plurality of duty detection signals DCD-OUTP and DCD-OUTN. The plurality of duty detection signals DCD-OUTP and DCD-OUTN include a first duty detection signal DCD-OUTP and a second duty detection signal DCD-OUTN.

The duty detection circuit 110, during an offset adjustment interval, adjusts an offset decision bit among a plurality of offset control codes, determines whether offset compensation of the duty detection circuit 110 is performed based on a phase difference of the multiphase clock signals ICK, QCK, IBCK, and QBCK, and when offset compensation is determined to be performed, compensates for offset by adjusting offset adjustment bits excluding the offset decision bit among the plurality of offset control codes.

The duty detection circuit 110, during a duty cycle adjustment interval, generates the plurality of duty detection signals DCD-OUTP and DCD-OUTN by detecting a phase difference of the multiphase clock signals ICK, QCK, IBCK, and QBCK based on the plurality of offset control codes set during the offset adjustment interval and the plurality of control signals DCC-CTRLA.

The duty control circuit 120 receives the plurality of duty detection signals DCD-OUTP and DCD-OUTN and outputs the plurality of duty control codes CC<m:0>, CF<n:0>, NC<m:0>, and NF<n:0> and the plurality of control signals DCC-CTRLA. The plurality of control signals DCC-CTRLA include control signals that control the duty detection circuit 110 during the offset adjustment interval and the duty cycle adjustment interval. The duty control circuit 120 adjusts values of the plurality of duty control codes CC<m:0>, CF<n:0>, NC<m:0>, and NF<n:0> according to the plurality of duty detection signals DCD-OUTP and DCD-OUTN.

The duty control circuit 120 detects whether a bang-bang state of the plurality of duty control codes CC<m:0>,CF<n:0>, NC<m:0>, and NF<n:0> occurs and stops adjustment of the plurality of duty control codes CC<m:0>, CF<n:0>, NC<m:0>, and NF<n:0> when the bang-bang state is detected.

The duty control circuit 120 selectively controls the first duty adjustment circuit 101A and the second duty adjustment circuit 101B. When the first duty adjustment circuit 101A is selected, the duty control circuit 120 adjusts the first code CC<m:0> and the second code CF<n:0> according to the plurality of duty detection signals DCD-OUTP and DCD-OUTN. When the second duty adjustment circuit 101B is selected, the duty control circuit 120 adjusts the third code NC<m:0> and the fourth code NF<n:0> according to the duty detection signals DCD-OUTP and DCD-OUTN.

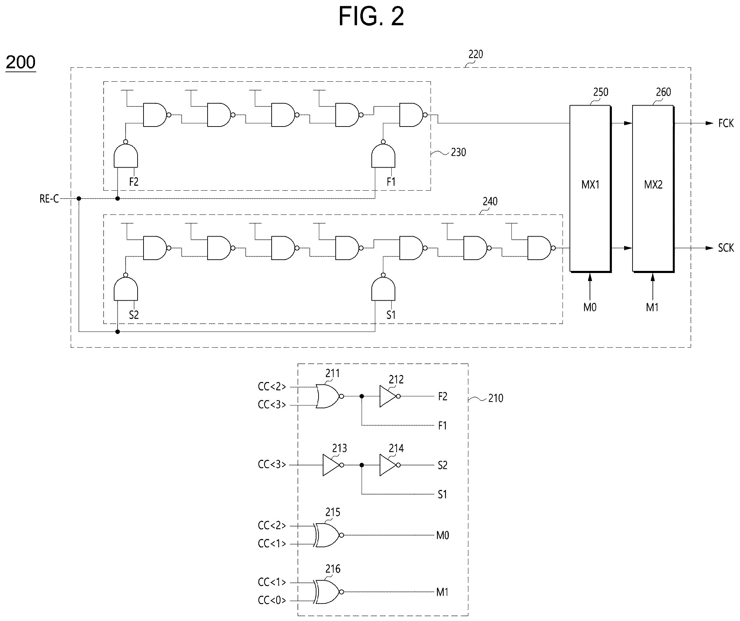

FIG. 2 is a diagram illustrating a configuration of the first adjustment circuit 200, for example, as shown in FIG. 1.

An example in which the duty cycle correction circuit 100 is configured with m = 3 and n = 7 in the plurality of duty control codes CC<m:0>, CF<n:0>, NC<m:0>, and NF<n:0> is described.

Referring to FIG. 2, the first adjustment circuit 200 includes a delay control signal generation circuit 210 and a delay circuit 220.

The delay control signal generation circuit 210 receive a first code CC<3:0> and outputs a plurality of delay control signals F<2:1>, S<2:1>, and M<1:0>. The delay control signal generation circuit 210 includes a plurality of logic gates 211 to 216. The first logic gate 211 outputs, as the delay control signal F1, a result obtained by performing a NOR operation on the first code CC<2> and the first code CC<3>. The second logic gate 212 outputs, as the delay control signal F2, a result obtained by inverting the delay control signal F1. The third logic gate 213 outputs, as the delay control signal S1, a result obtained by inverting the first code CC<3>. The fourth logic gate 214 outputs, as the delay control signal S<2>, a result obtained by inverting the delay control signal S1. The fifth logic gate 215 outputs a result obtained by performing an exclusive NOR operation on the first code CC<2> and the first code CC<1> as the delay control signal M0. The sixth logic gate 216 outputs a result obtained by performing an exclusive NOR operation on the first code CC<0> and the first code CC<1> as the delay control signal M1.

The delay circuit 220 delays the first external clock signal RE-C by a time corresponding to the plurality of delay control signals F<2:1>, S<2:1>, and M<1:0> to generate the first clock signal FCK and the second clock signal SCK. The delay circuit 220 includes a first delay line 230, a second delay line 240, a first phase mixing circuit MX1 250, and a second phase mixing circuit MX2 260. The first delay line 230 delays the first external clock signal RE-C by a time corresponding to the plurality of delay control signals F<2:1> and outputs the delayed signal. The first delay line 230 includes a plurality of logic gates, for example, a plurality of NAND gates, and adjusts a delay time of the first external clock signal RE-C by varying the number of NAND gates through which the first external clock signal RE-C passes according to the plurality of delay control signals F<2:1>. The second delay line 240 delays the first external clock signal RE-C by a time corresponding to the plurality of delay control signals S<2:1> and outputs the delayed signal. The first phase mixing circuit 250 outputs a result obtained by mixing the outputs of the first delay line 230 and the second delay line 240 at a predetermined ratio according to the delay control signal M<0>. The second phase mixing circuit 260 outputs a result obtained by mixing the outputs of the first phase mixing circuit 250 at a predetermined ratio according to the delay control signal M<1> as the first clock signal FCK and the second clock signal SCK.

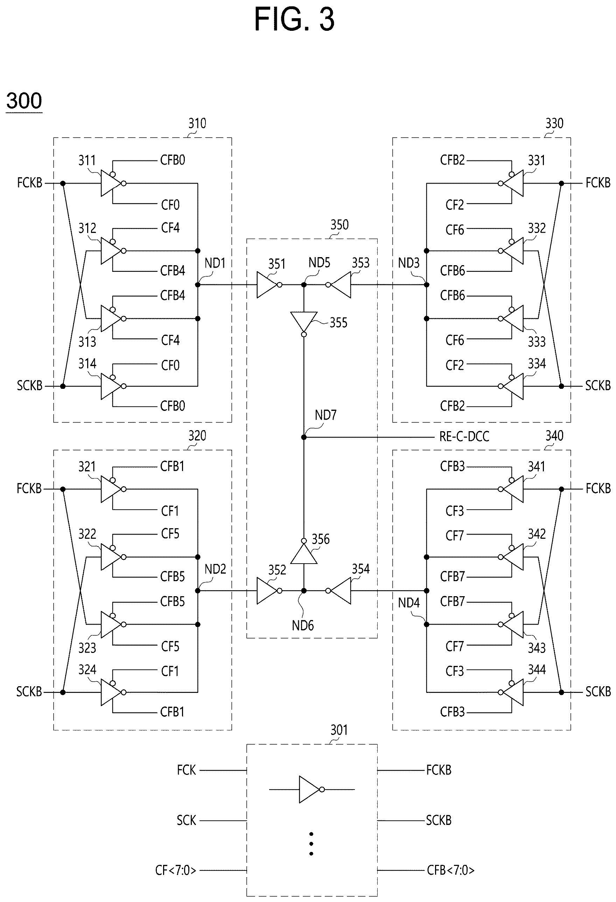

FIG. 3 is a diagram illustrating a configuration of the second adjustment circuit 300, for example, as shown in FIG. 1.

Referring to FIG. 3, the second adjustment circuit 300 include an inverting circuit 301, a plurality of sub-circuits 310, 320, 330, and 340, and a main circuit 350.

The inverting circuit 301 inverts the first clock signal FCK, the second clock signal SCK, and the second code CF<7:0> to generate an inverted first clock signal FCKB, an inverted second clock signal SCKB, and an inverted second code CFB<7:0>, respectively. The inverting circuit 301 includes a plurality of inverters.

Each of the plurality of sub-circuits 310, 320, 330, and 340 selectively outputs one of the inverted first clock signal FCKB and the inverted second clock signal SCKB according to the second code CF<7:0> and the inverted second code CFB<7:0>.

The first sub-circuit 310 selectively outputs one of the inverted first clock signal FCKB and the inverted second clock signal SCKB according to the second code CF0, CF4 and the inverted second code CFB0, CFB4. The first sub-circuit 310 includes a plurality of logic gates 311 to 314. Outputs of the plurality of logic gates 311 to 314 is connected in common to a first node ND1.

The second sub-circuit 320 selectively outputs one of the inverted first clock signal FCKB and the inverted second clock signal SCKB according to the second code CF1, CF5 and the inverted second code CFB1, CFB5. The second sub-circuit 320 includes a plurality of logic gates 321 to 324. Outputs of the plurality of logic gates 321 to 324 are connected in common to a second node ND2.

The third sub-circuit 330 selectively outputs one of the inverted first clock signal FCKB and the inverted second clock signal SCKB according to the second code CF2, CF6 and the inverted second code CFB2, CFB6. The third sub-circuit 330 includes a plurality of logic gates 331 to 334. Outputs of the plurality of logic gates 331 to 334 are connected in common to a third node ND3.

The fourth sub-circuit 340 selectively outputs one of the inverted first clock signal FCKB and the inverted second clock signal SCKB according to the second code CF3, CF7 and the inverted second code CFB3, CFB7. The fourth sub-circuit 340 includes a plurality of logic gates 341 to 344. Outputs of the plurality of logic gates 341 to 344 are connected in common to the fourth node ND4.

The plurality of sub-circuits 310, 320, 330, and 340 are configured and operate similarly, thus a configuration and operation of the first sub-circuit 310 is described. The first logic gate 311 outputs, at the first node ND1, a result obtained by inverting the inverted first clock signal FCKB when the second code CF0 is at a high logic level. The second logic gate 312 outputs, at the first node ND1, a result obtained by inverting the inverted second clock signal SCKB when the second code CF4 is at a low logic level. The third logic gate 313 outputs, at the first node ND1, a result obtained by inverting the inverted first clock signal FCKB when the second code CF4 is at a high logic level. The fourth logic gate 314 outputs, at the first node ND1, a result obtained by inverting the inverted second clock signal SCKB when the second code CF0 is at a low logic level.

The main circuit 350 outputs, as the first duty correction clock signal RE-C-DCC, a result obtained by mixing phases of signals applied to outputs of the plurality of sub-circuits 310, 320, 330, and 340, thus, the signals applied to the nodes ND1 to ND4. The main circuit 350 includes a plurality of logic gates 351 to 356. The first logic gate 351 outputs, at a fifth node ND5, a result obtained by inverting a signal at the first node ND1. The second logic gate 352 outputs, at a sixth node ND6, a result obtained by inverting a signal at the second node ND2. The third logic gate 353 outputs, at the fifth node ND5, a result obtained by inverting a signal from the third node ND3. The fourth logic gate 354 outputs, at the sixth node ND6, a result obtained by inverting a signal at the fourth node ND4. The fifth logic gate 355 outputs, at a seventh node ND7, a result obtained by inverting a signal at the fifth node ND5. The sixth logic gate 356 outputs, at the seventh node ND7, a result obtained by inverting a signal at the sixth node ND6. The first duty correction clock signal RE-C-DCC is output at the seventh node ND7.

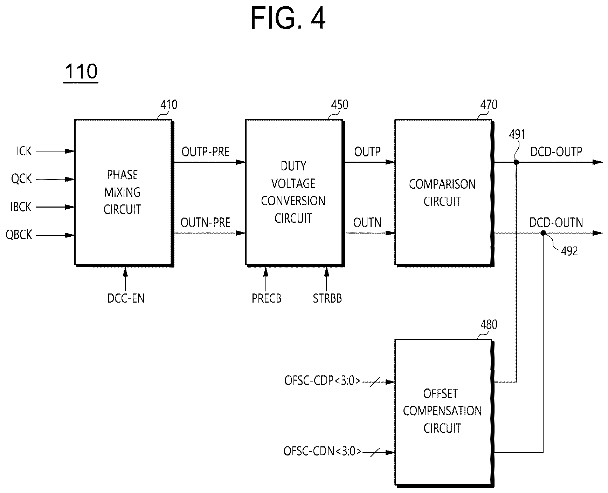

FIG. 4 is a diagram illustrating a configuration of the duty detection circuit 110, for example, as shown in FIG. 1.

Referring to FIG. 4, the duty detection circuit 110 includes a phase mixing circuit 410, a duty voltage conversion circuit 450, a comparison circuit 470, and an offset compensation circuit 480. The plurality of control signals DCC-CTRLA of FIG. 1 include a duty cycle adjustment enable signal DCC-EN, a precharge signal PRECB, a strobe signal STRBB, and a plurality of offset control codes OFSC-CDP<3:0> and OFSC-CDN<3:0>. The plurality of offset control codes includes a first offset control code OFSC-CDP<3:0> and a second offset control code OFSC-CDN<3:0>. The first offset control code includes a first offset decision bit OFSC-CDP<0> and first offset adjustment bits OFSC-CDP<3:1>. The second offset control code includes a second offset decision bit OFSC-CDN<0> and second offset adjustment bits OFSC-CDN<3:1>.

The phase mixing circuit 410 receives the multiphase clock signals ICK, QCK, IBCK, and QBCK and the duty cycle adjustment enable signal DCC-EN and outputs a plurality of duty signals OUTP-PRE and OUTN-PRE. The phase mixing circuit 410 generates the plurality of duty signals OUTP-PRE and OUTN-PRE by mixing the multiphase clock signals in a predetermined combination during an interval in which the duty cycle adjustment enable signal DCC-EN is activated. The plurality of duty signals OUTP-PRE and OUTN-PRE includes a first duty signal OUTP-PRE and a second duty signal OUTN-PRE. When the duty cycle adjustment enable signal DCC-EN is deactivated, the phase mixing circuit 410 fixes the plurality of duty signals OUTP-PRE and OUTN-PRE at a predetermined logic level. Activation of a signal indicates, for example, that the signal is maintained at a first logic level, such as a high logic level, or a second logic level, such as a low logic level.

The duty voltage conversion circuit 450 receives the plurality of duty signals OUTP-PRE and OUTN-PRE, the precharge signal PRECB, and the strobe signal STRBB and outputs a plurality of duty voltage signals OUTP and OUTN. The duty voltage conversion circuit 450 precharges output nodes to a power level according to the precharge signal PRECB and generates the plurality of duty voltage signals OUTP and OUTN by adjusting a current according to the strobe signal STRBB and the plurality of duty signals OUTP-PRE and OUTN-PRE. The plurality of duty voltage signals OUTP and OUTN includes a first duty voltage signal OUTP and a second duty voltage signal OUTN.

The comparison circuit 470 receives the plurality of duty voltage signals OUTP and OUTN and outputs the plurality of duty detection signals DCD-OUTP and DCD-OUTN. The comparison circuit 470 outputs the first duty detection signal DCD-OUTP at a first output terminal 491 and outputs the second duty detection signal DCD-OUTN at a second output terminal 492. The comparison circuit 470 generates the plurality of duty detection signals DCD-OUTP and DCD-OUTN by comparing phases of the plurality of duty voltage signals OUTP and OUTN.

The offset compensation circuit 480 is coupled to output terminals of the comparison circuit 470, that correspond to the output terminals of the duty detection circuit 110. The offset compensation circuit 480 receives the plurality of offset control codes OFSC-CDP<3:0> and OFSC-CDN<3:0>, which include the first offset control code OFSC-CDP<3:0> and the second offset control code OFSC-CDN<3:0>.

The offset compensation circuit 480 adjusts the offset decision bits OFSC-CDP<0> and OFSC-CDN<0>, determines whether to perform offset compensation for the duty detection circuit 110 based on a phase difference between the plurality of duty detection signals DCD-OUTP and DCD-OUTN, and, when offset compensation is to be performed, adjusts the offset adjustment bits OFSC-CDP<3:1> and OFSC-CDN<3:1> to compensate for offset at the output terminals of the duty detection circuit 110.

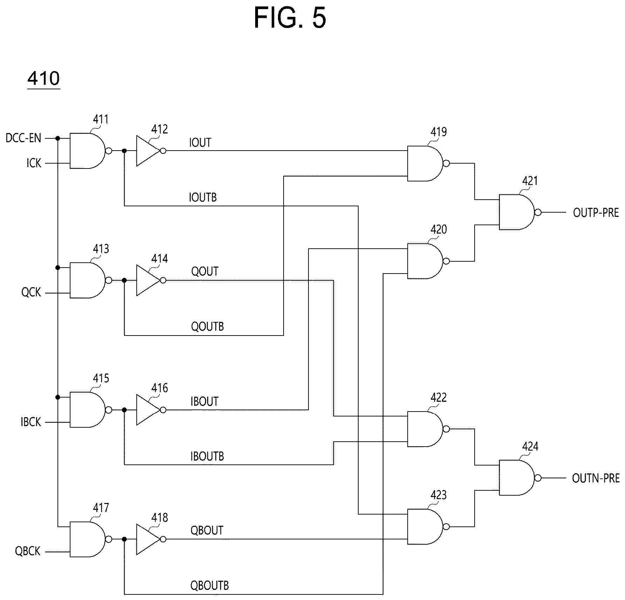

FIG. 5 is a diagram illustrating a configuration of the phase mixing circuit 410, for example, as shown in FIG. 4.

Referring to FIG. 5, the phase mixing circuit 410 includes a plurality of logic gates 411 to 424. The first logic gate 411 generates an output IOUTB by performing a NAND operation on the duty cycle adjustment enable signal DCC-EN and the first phase clock signal ICK. The second logic gate 412 outputs a signal IOUT by inverting the output IOUTB of the first logic gate 411. The third logic gate 413 generates an output QOUTB by performing a NAND operation on the duty cycle adjustment enable signal DCC-EN and the second phase clock signal QCK. The fourth logic gate 414 outputs a signal QOUT by inverting the output QOUTB of the third logic gate 413. The fifth logic gate 415 generates an output IBOUTB by performing a NAND operation on the duty cycle adjustment enable signal DCC-EN and the third phase clock signal IBCK. The sixth logic gate 416 outputs a signal IBOUT by inverting the output IBOUTB of the fifth logic gate 415. The seventh logic gate 417 generates an output QBOUTB by performing a NAND operation on the duty cycle adjustment enable signal DCC-EN and the fourth phase clock signal QBCK. The eighth logic gate 418 outputs a signal QBOUT by inverting the output QBOUTB of the seventh logic gate 417. The ninth logic gate 419 outputs a result obtained by performing a NAND operation on the signal IOUT and the signal QOUTB. The tenth logic gate 420 outputs a result obtained by performing a NAND operation on the signal IBOUT and the signal QBOUTB. The eleventh logic gate 421 outputs, as the first duty signal OUTP-PRE, a result obtained by performing a NAND operation on an output of the ninth logic gate 419 and an output of the tenth logic gate 420. The twelfth logic gate 422 outputs a result obtained by performing a NAND operation on the signal QOUT and the signal IBOUTB. The thirteenth logic gate 423 outputs a result obtained by performing a NAND operation on the signal IOUTB and the signal QBOUT. The fourteenth logic gate 424 outputs, as the second duty signal OUTN-PRE, a result obtained by performing a NAND operation on an output of the twelfth logic gate 422 and an output of the thirteenth logic gate 423.

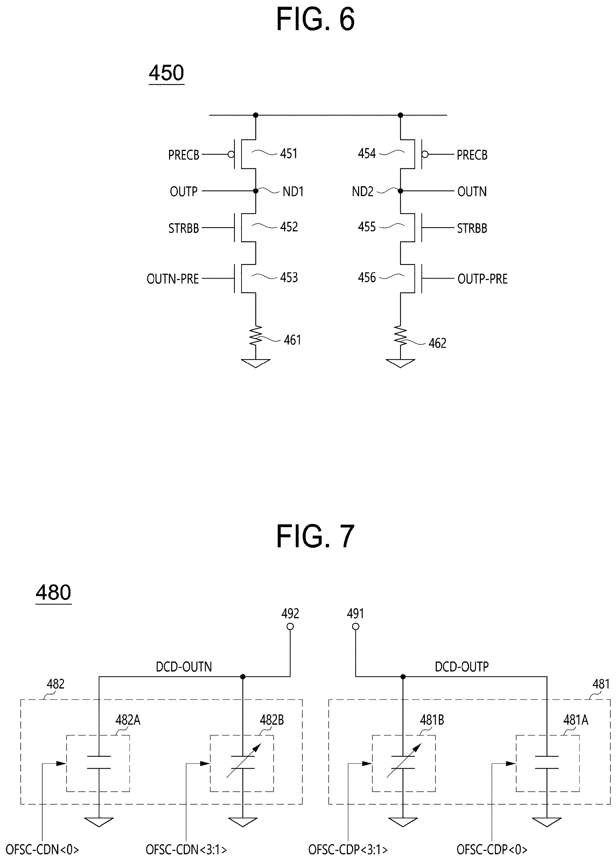

FIG. 6 is a diagram illustrating a configuration of the duty voltage conversion circuit 450, for example, as shown in FIG. 4.

Referring to FIG. 6, the duty voltage conversion circuit 450 includes a plurality of transistors 451 to 456 and a plurality of resistors 461 and 462.

The first transistor 451 is coupled between a power supply terminal and a first output node ND1 and is controlled according to the precharge signal PRECB. The second transistor 452 is coupled to the first output node ND1 and is controlled according to the strobe signal STRBB. The third transistor 453 is coupled to the second transistor 452 and is controlled according to the second duty signal OUTN-PRE. The first resistor 461 is coupled between the third transistor 453 and a ground terminal. The first duty voltage signal OUTP is output at the first output node ND1. The fourth transistor 454 is coupled between the power supply terminal and a second output node ND2 and is controlled according to the precharge signal PRECB. The fifth transistor 455 is coupled to the second output node ND2 and is controlled according to the strobe signal STRBB. The sixth transistor 456 is coupled to the fifth transistor 455 and is controlled according to the first duty signal OUTP-PRE. The second resistor 462 is coupled between the sixth transistor 456 and the ground terminal. The second duty voltage signal OUTN is output at the second output node ND2.

While the precharge signal PRECB is maintained at a logic low level, the first duty voltage signal OUTP and the second duty voltage signal OUTN are precharged to a power supply voltage level. During an interval in which the precharge signal PRECB and the strobe signal STRBB are maintained at a logic high level, amounts of current flowing through the first resistor 461 and the second resistor 462 are adjusted differently according to the first duty signal OUTP-PRE and the second duty signal OUTN-PRE, and the first duty voltage signal OUTP and the second duty voltage signal OUTN corresponding to the difference in current is generated.

FIG. 7 is a diagram illustrating a configuration of the offset compensation circuit 480, for example, as shown in FIG. 4.

Referring to FIG. 7, the offset compensation circuit 480 includes a first compensation circuit 481 and a second compensation circuit 482.

The first compensation circuit 481 is coupled to the first output terminal 491 of the duty detection circuit 110. The first compensation circuit 481 includes a first capacitance circuit 481A and a first variable capacitance circuit 481B. The first capacitance circuit 481A and the first variable capacitance circuit 481B are coupled in parallel to the first output terminal 491. The first capacitance circuit 481A applies a first capacitance to the first output terminal 491 according to the first offset decision bit OFSC-CDP<0>. The first variable capacitance circuit 481B varies or adjusts a second capacitance according to the first offset adjustment bits OFSC-CDP<3:1> and applies the second capacitance to the first output terminal 491. The second capacitance is varied within a range from X to X*n, where X is a default value and n is a natural number. The X*n indicates n multiplied by X. The first capacitance has a value of 0.5X, a capacitance equal to half of the default value of the second capacitance.

The second compensation circuit 482 is coupled to the second output terminal 492 of the duty detection circuit 110. The second compensation circuit 482 includes a second capacitance circuit 482A and a second variable capacitance circuit 482B. The second capacitance circuit 482A is configured substantially similarly to the first capacitance circuit 481A, and the second variable capacitance circuit 482B is configured substantially similarly to the first variable capacitance circuit 481B. The second capacitance circuit 482A and the second variable capacitance circuit 482B are coupled in parallel to the second output terminal 492. The second capacitance circuit 482A applies a third capacitance to the second output terminal 492 according to the second offset decision bit OFSC-CDN<0>. The second variable capacitance circuit 482B varies or adjusts a fourth capacitance according to the second offset adjustment bits OFSC-CDN<3:1> and applies the fourth capacitance to the second output terminal 492. The fourth capacitance is varied within a range from Y to Y*n, where Y is a default value and n is a natural number. The Y*n indicates n multiplied by Y. The third capacitance has a value of 0.5Y, a capacitance equal to half of the default value of the fourth capacitance. The third capacitance may have the same value as the first capacitance, and a capacitance according to the default value Y of the fourth capacitance may be the same as a capacitance according to the default value X of the second capacitance.

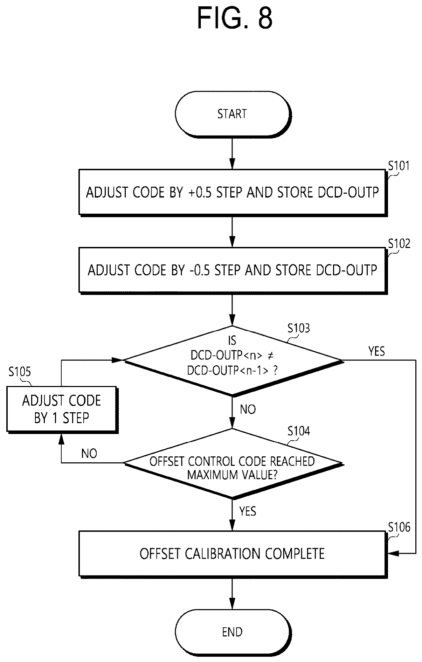

FIG. 8 is a flowchart illustrating an offset adjustment operation of the duty detection circuit 100 according to an embodiment of the present disclosure. The offset adjustment operation of the duty detection circuit 100 is controlled by the duty control circuit 120. The processes of the flowchart may be performed in a different order and may include fewer or additional processes than described and shown in FIG. 8.

The duty detection circuit 100 operates during an offset adjustment interval for a predetermined time interval, for example, during an initialization interval.

When the offset adjustment interval is initiated, a code is adjusted S101 by +0.5 step, and a resulting value of the first duty detection signal DCD-OUTP is stored. The first offset decision bit OFSC-CDP<0> is restored to a logic low level.

A capacitance variation resulting from adjusting the first offset decision bit OFSC-CDP<0> or the second offset decision bit OFSC-CDN<0> is half of a capacitance variation resulting from adjusting the first offset adjustment bits OFSC-CDP<3:1> or the second offset adjustment bits OFSC-CDN<3:1> by one step. Therefore, the code is adjusted by +0.5 step by setting the first offset decision bit OFSC-CDP<0> or the second offset decision bit OFSC-CDN<0> at a logic high level. According to an embodiment of the present disclosure, the code is adjusted by +0.5 step by setting the first offset decision bit OFSC-CDP<0> to a logic high level.

The code is adjusted S102 by -0.5 step. The -0.5 step code adjustment is performed by setting the second offset decision bit OFSC-CDN<0> related to an offset of the second duty detection signal DCD-OUTN to a logic high level. A value of the first duty detection signal DCD-OUTP is stored, and the second offset decision bit OFSC-CDN<0> is restored to a logic low level.

Whether a value DCD-OUTP<n> of the obtained first duty detection signal DCD-OUTP is different from a value DCD-OUTP<n-1> of the first duty detection signal DCD-OUTP is determined S103. Whether offset compensation is performed is determined using S101 to S103.

When the determination S103 indicates that the value DCD-OUTP<n> and the value DCD-OUTP<n-1> are the same, the offset has deviated outside an error range and offset compensation is performed.

Whether the first offset control code OFSC-CDP<3:0> or the second offset control code OFSC-CDN<3:0> has reached a maximum value is determined S104.

When neither the first offset control code OFSC-CDP<3:0> nor the second offset control code OFSC-CDN<3:0> is determined S104 to have reach the maximum value, the code is adjusted S105 by +1 step, and the process returns to S103.

When the value of the first duty detection signal DCD-OUTP is at a logic high level 1, the first offset adjustment bits OFSC-CDP<3:1> are increased S105 by one step. When the value of the second duty detection signal DCD-OUTN is at a logic high level 1, the second offset adjustment bits OFSC-CDN<3:1> are increased S105 by one step.

When the determination result S103 indicates that the value DCD-OUTP<n> differs from the value DCD-OUTP<n-1>, the offset is compensated or adjusted to a value within an error range and the offset adjustment is completed S106.

When the determination S104 indicates that the first offset control code OFSC-CDP<3:0> or the second offset control code OFSC-CDN<3:0> has reached the maximum value, the offset adjustment is determined to be completed S106.

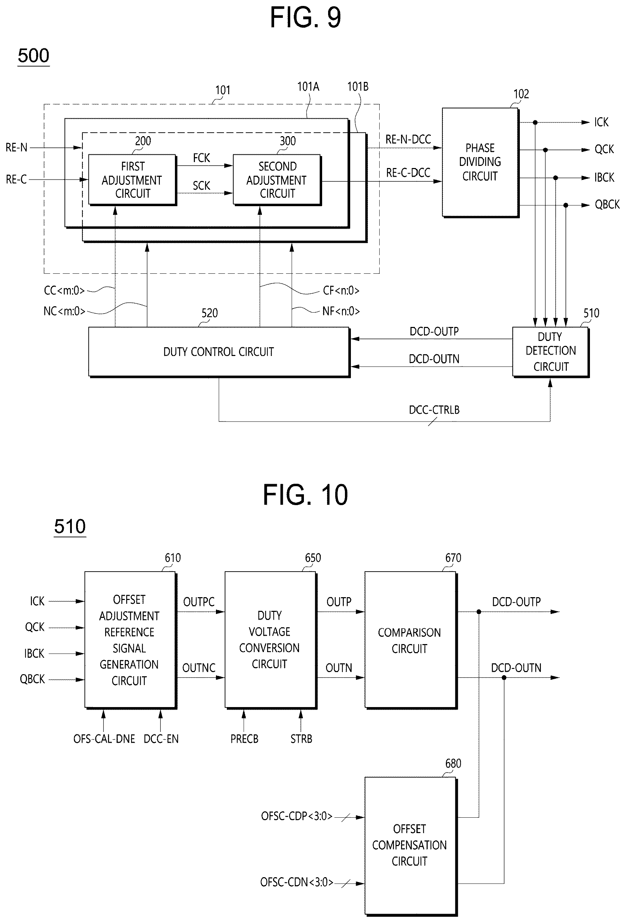

FIG. 9 is a diagram illustrating a configuration of a duty cycle correction circuit 500 according to an embodiment of the present disclosure.

Referring to FIG. 9, the duty cycle correction circuit 500 includes the duty adjustment circuit 101, the phase dividing circuit 102, a duty detection circuit 510, and a duty control circuit 520.

The duty adjustment circuit 101 receives the plurality of external clock signals RE-C and RE-N and the plurality of duty control codes CC<m:0>, CF<n:0>, NC<m:0>, and NF<n:0>, and outputs the plurality of duty correction clock signals RE-C-DCC and RE-N-DCC. The duty adjustment circuit 101 is configured substantially similarly to the duty adjustment circuit 101 as in FIG. 1.

The phase dividing circuit 102 receives the first duty correction clock signal RE-C-DCC and the second duty correction clock signal RE-N-DCC and outputs the multiphase clock signals ICK, QCK, IBCK, and QBCK. The phase dividing circuit 102 divides phases of the first duty correction clock signal RE-C-DCC and the second duty correction clock signal RE-N-DCC to generate the multiphase clock signals ICK, QCK, IBCK, and QBCK.

The duty detection circuit 510 receives a plurality of control signals DCC-CTRLB and the multiphase clock signals ICK, QCK, IBCK, and QBCK and outputs a plurality of duty detection signals DCD-OUTP and DCD-OUTN.

The duty detection circuit 510 generates a plurality of offset adjustment reference signals having a target duty cycle, such as a duty cycle of 50:50, regardless of the duty cycle of the multiphase clock signals ICK, QCK, IBCK, and QBCK, by using the multiphase clock signals. A duty cycle of 50:50 indicates a duty cycle of 50:50 within an allowable margin of error. During an offset adjustment interval, the duty detection circuit 510 adjusts an offset decision bit among a plurality of offset control codes, determine whether to perform offset compensation for the duty detection circuit 510 based on a phase difference of the resulting offset adjustment reference signals, and, when offset compensation is performed, compensates for the offset by adjusting offset adjustment bits excluding the offset decision bit among the plurality of offset control codes.

During a duty cycle adjustment interval, the duty detection circuit 510 generates the plurality of duty detection signals DCD-OUTP and DCD-OUTN by detecting a phase difference of the multiphase clock signals ICK, QCK, IBCK, and QBCK based on the offset control codes set during the offset adjustment interval and according to the plurality of control signals DCC-CTRLB.

The duty control circuit 520 receives the plurality of duty detection signals DCD-OUTP and DCD-OUTN and outputs the plurality of codes CC<m:0>, CF<n:0>, NC<m:0>, and NF<n:0> and the plurality of control signals DCC-CTRLB. The plurality of control signals DCC-CTRLB includes control signals that control the duty detection circuit 510 during the offset adjustment interval and the duty cycle adjustment interval. The duty control circuit 520 adjusts values of the plurality of duty control codes CC<m:0>, CF<n:0>, NC<m:0>, and NF<n:0> according to the plurality of duty detection signals DCD-OUTP and DCD-OUTN.

The duty control circuit 520 detects whether a bang-bang state of the plurality of duty control codes CC<m:0>,CF<n:0>, NC<m:0>, and NF<n:0> occurs and stops adjustment of the plurality of duty control codes CC<m:0>, CF<n:0>, NC<m:0>, and NF<n:0> when the bang-bang state is detected.

The duty control circuit 520 selectively controls the first duty adjustment circuit 101A and the second duty adjustment circuit 101B. When the first duty adjustment circuit 101A is selected, the duty control circuit 520 adjusts the first code CC<m:0> and the second code CF<n:0> according to the plurality of duty detection signals DCD-OUTP and DCD-OUTN. When the second duty adjustment circuit 101B is selected, the duty control circuit 520 adjusts the third code NC<m:0> and the fourth code NF<n:0> according to the duty detection signals DCD-OUTP and DCD-OUTN.

FIG. 10 is a diagram illustrating a configuration of the duty detection circuit 510, for example, as shown in FIG. 9.

Referring to FIG. 10, the duty detection circuit 510 includes an offset adjustment reference signal generation circuit 610, a duty voltage conversion circuit 650, a comparison circuit 670, and an offset compensation circuit 680. The plurality of control signals DCC-CTRLB includes an offset calibration complete signal OFS-CAL-DNE, a duty cycle adjustment enable signal DCC-EN, a precharge signal PRECB, a strobe signal STRBB, and a plurality of offset control codes OFSC-CDP<3:0> and OFSC-CDN<3:0>.

The offset adjustment reference signal generation circuit 610 receives the multiphase clock signals ICK, QCK, IBCK, and QBCK, the offset calibration complete signal OFS-CAL-DNE, and the duty cycle adjustment enable signal DCC-EN and outputs a plurality of offset adjustment reference signals OUTPC and OUTNC. The plurality of offset adjustment reference signals OUTPC and OUTNC include a first offset adjustment reference signal OUTPC and a second offset adjustment reference signal OUTNC.

In an embodiment, he offset adjustment reference signal generation circuit 610 generates the plurality of offset adjustment reference signals OUTPC and OUTNC having a duty cycle of 50:50, regardless of the duty cycle of the multiphase clock signals ICK, QCK, IBCK, and QBCK, by combining differently the multiphase clock signals according to the offset calibration complete signal OFS-CAL-DNE.

The duty voltage conversion circuit 650 receives the plurality of offset adjustment reference signals OUTPC and OUTNC, the precharge signal PRECB, and the strobe signal STRBB and outputs a plurality of duty voltage signals OUTP and OUTN. The duty voltage conversion circuit 650 precharges output nodes to a power level according to the precharge signal PRECB and generates the plurality of duty voltage signals OUTP and OUTN by adjusting an amount of current based on the strobe signal STRBB and the plurality of duty signals OUTP-PRE and OUTN-PRE. The duty voltage conversion circuit 650 is configured substantially similarly to the duty voltage conversion circuit 450 of FIG. 4.

The comparison circuit 670 receives the plurality of duty voltage signals OUTP and OUTN and outputs the plurality of duty detection signals DCD-OUTP and DCD-OUTN. The comparison circuit 670 generates the plurality of duty detection signals DCD-OUTP and DCD-OUTN by comparing phases of the plurality of duty voltage signals OUTP and OUTN.

The offset compensation circuit 680 receives the plurality of offset control codes OFSC-CDP<3:0> and OFSC-CDN<3:0>. The offset compensation circuit 680 adjusts the offset decision bits OFSC-CDP<0> and OFSC-CDN<0>, determines whether to perform offset compensation for the duty detection circuit 510 based on a phase difference of the plurality of duty detection signals DCD-OUTP and DCD-OUTN, and, when offset compensation is performed, compensates for an offset at an output terminal of the duty detection circuit 510 by adjusting the offset adjustment bits OFSC-CDP<3:1> and OFSC-CDN<3:1>. The offset compensation circuit 680 is configured substantially similarly to the offset compensation circuit 480 of FIG. 4.

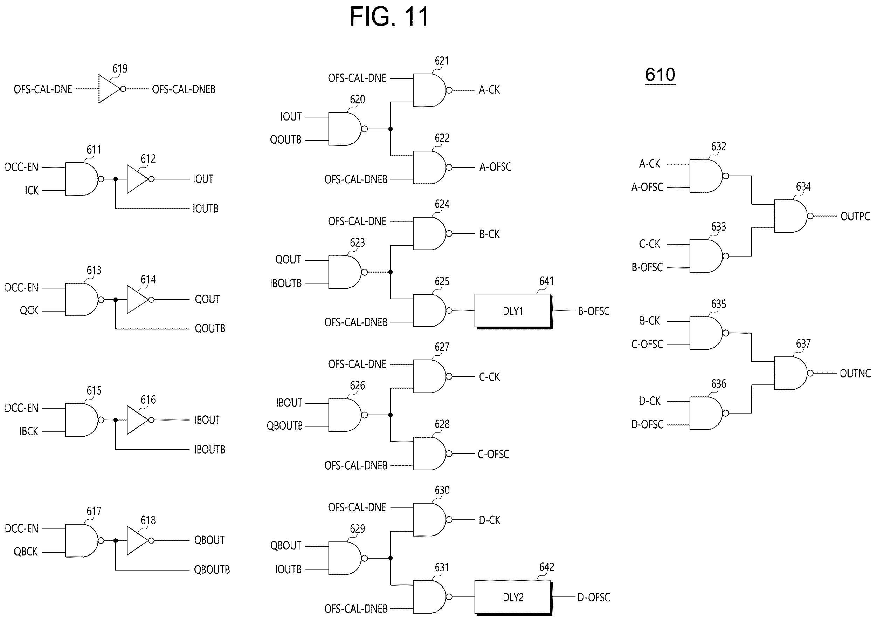

FIG. 11 is a diagram illustrating a configuration of the offset adjustment reference signal generation circuit 610, for example, as shown in FIG. 10.

Referring to FIG. 11, the offset adjustment reference signal generation circuit 610 includes a plurality of logic gates 611 to 637 and a plurality of delay circuits 641 and 642. The first logic gate 611 performs a NAND operation on the duty cycle adjustment enable signal DCC-EN and the first phase clock signal ICK to generate an output IOUTB. The second logic gate 612 outputs a signal IOUT obtained by inverting the output IOUTB from the first logic gate 611. The third logic gate 613 performs a NAND operation on the duty cycle adjustment enable signal DCC-EN and the second phase clock signal QCK to generate an output QOUTB. The fourth logic gate 614 outputs a signal QOUT obtained by inverting the output QOUTB from the third logic gate 613. The fifth logic gate 615 performs a NAND operation on the duty cycle adjustment enable signal DCC-EN and the third phase clock signal IBCK to generate an output IBOUTB. The sixth logic gate 616 outputs a signal IBOUT obtained by inverting the output IBOUTB from the fifth logic gate 615. The seventh logic gate 617 performs a NAND operation on the duty cycle adjustment enable signal DCC-EN and the fourth phase clock signal QBCK to generate an output QBOUTB. The eighth logic gate 618 outputs a signal QBOUT obtained by inverting the output QBOUTB of the seventh logic gate 617. The ninth logic gate 619 inverts the offset calibration complete signal OFS-CAL-DNE to generate an inverted offset calibration complete signal OFS-CAL-DNEB. The tenth logic gate 620 outputs a result obtained by performing a NAND operation on the signal IOUT and the signal QOUTB. The eleventh logic gate 621 performs a NAND operation on the offset calibration complete signal OFS-CAL-DNE and an output from the tenth logic gate 620 to generate a first normal preliminary signal A-CK. The twelfth logic gate 622 performs a NAND operation on the inverted offset calibration complete signal OFS-CAL-DNEB and the output from the tenth logic gate 620 to generate a first offset preliminary signal A-OFSC. The thirteenth logic gate 623 outputs a result obtained by performing a NAND operation on the signal QOUT and the signal IBOUTB. The fourteenth logic gate 624 performs a NAND operation on the offset calibration complete signal OFS-CAL-DNE and an output from the thirteenth logic gate 623 to generate a second normal preliminary signal B-CK. The fifteenth logic gate 625 performs a NAND operation on the inverted offset calibration complete signal OFS-CAL-DNEB and the output from the thirteenth logic gate 623. The first delay circuit 641 DLY1 delays an output from the fifteenth logic gate 625 by a predetermined time to generate a second offset preliminary signal B-OFSC. The sixteenth logic gate 626 outputs a result obtained by performing a NAND operation on the signal IBOUT and the signal QBOUTB. The seventeenth logic gate 627 performs a NAND operation on the offset calibration complete signal OFS-CAL-DNE and an output from the sixteenth logic gate 626 to generate a third normal preliminary signal C-CK. The eighteenth logic gate 628 performs a NAND operation on the inverted offset calibration complete signal OFS-CAL-DNEB and the output from the sixteenth logic gate 626 to generate a third offset preliminary signal C-OFSC. The nineteenth logic gate 629 outputs a result obtained by performing a NAND operation on the signal QBOUT and the signal IOUTB. The twentieth logic gate 630 performs a NAND operation on the offset calibration complete signal OFS-CAL-DNE and an output from the nineteenth logic gate 629 to generate a fourth normal preliminary signal D-CK. The twenty-first logic gate 631 performs a NAND operation on the inverted offset calibration complete signal OFS-CAL-DNEB and the output from the nineteenth logic gate 629. The second delay circuit 642 DLY2 delays an output from the twenty-first logic gate 631 by a predetermined time to generate a fourth offset preliminary signal D-OFSC. The twenty-second logic gate 632 outputs a result obtained by performing a NAND operation on the first normal preliminary signal A-CK and the first offset preliminary signal A-OFSC. The twenty-third logic gate 633 outputs a result obtained by performing a NAND operation on the third normal preliminary signal C-CK and the second offset preliminary signal B-OFSC. The twenty-fourth logic gate 634 performs a NAND operation on outputs from the twenty-second logic gate 632 and the twenty-third logic gate 633 to output the first offset adjustment reference signal OUTPC. The twenty-fifth logic gate 635 outputs a result obtained by performing a NAND operation on the second normal preliminary signal B-CK and the third offset preliminary signal C-OFSC. The twenty-sixth logic gate 636 outputs a result obtained by performing a NAND operation on the fourth normal preliminary signal D-CK and the fourth offset preliminary signal D-OFSC. The twenty-seventh logic gate 637 performs a NAND operation on outputs from the twenty-fifth logic gate 635 and the twenty-sixth logic gate 636 to output the second offset adjustment reference signal OUTNC.

The offset adjustment reference signal generation circuit 610 generates the plurality of offset adjustment reference signals OUTPC and OUTNC by combining the multiphase clock signals ICK, QCK, IBCK, and QBCK in a first manner during the duty cycle adjustment interval, which occurs when the offset calibration complete signal OFS-CAL-DNE is at a logic high level. The generation operation in the first manner includes generating the first offset adjustment reference signal OUTPC by combining the first normal preliminary signal A-CK generated based on the first phase clock signal ICK and the third normal preliminary signal C-CK generated based on the third phase clock signal IBCK and generating the second offset adjustment reference signal OUTNC by combining the second normal preliminary signal B-CK generated based on the second phase clock signal QCK and the fourth normal preliminary signal D-CK generated based on the fourth phase clock signal QBCK.

The offset adjustment reference signal generation circuit 610 generates the plurality of offset adjustment reference signals OUTPC and OUTNC by combining the multiphase clock signals ICK, QCK, IBCK, and QBCK in a second manner during the offset adjustment interval, which occurs when the offset calibration complete signal OFS-CAL-DNE is at a logic low level. The generation operation in the second manner includes generating the first offset adjustment reference signal OUTPC by combining the first offset preliminary signal A-OFSC generated based on the first phase clock signal ICK and the second offset preliminary signal B-OFSC generated based on the second phase clock signal QCK and generating the second offset adjustment reference signal OUTNC by combining the third offset preliminary signal C-OFSC generated based on the third phase clock signal IBCK and the fourth offset preliminary signal D-OFSC generated based on the fourth phase clock signal QBCK.

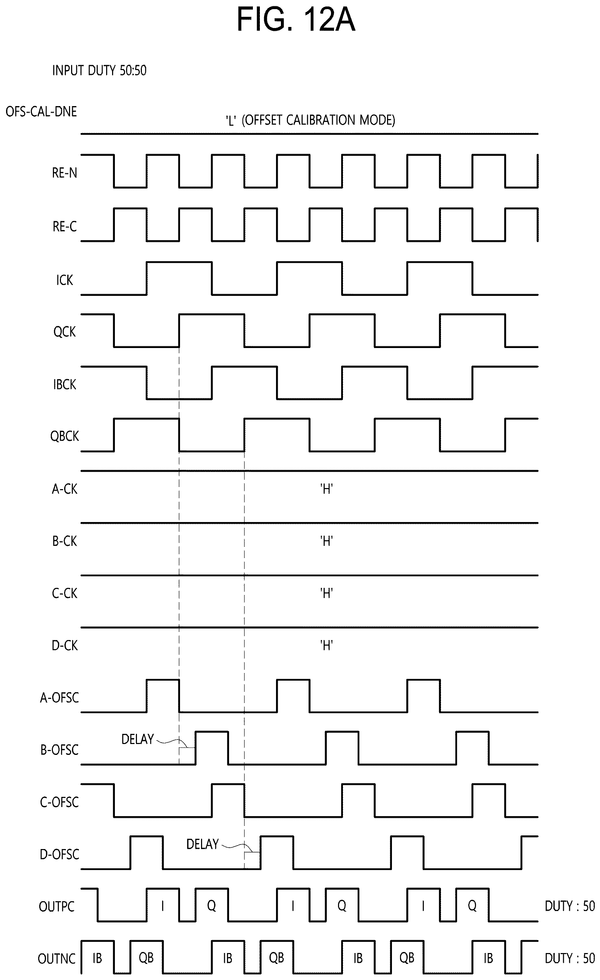

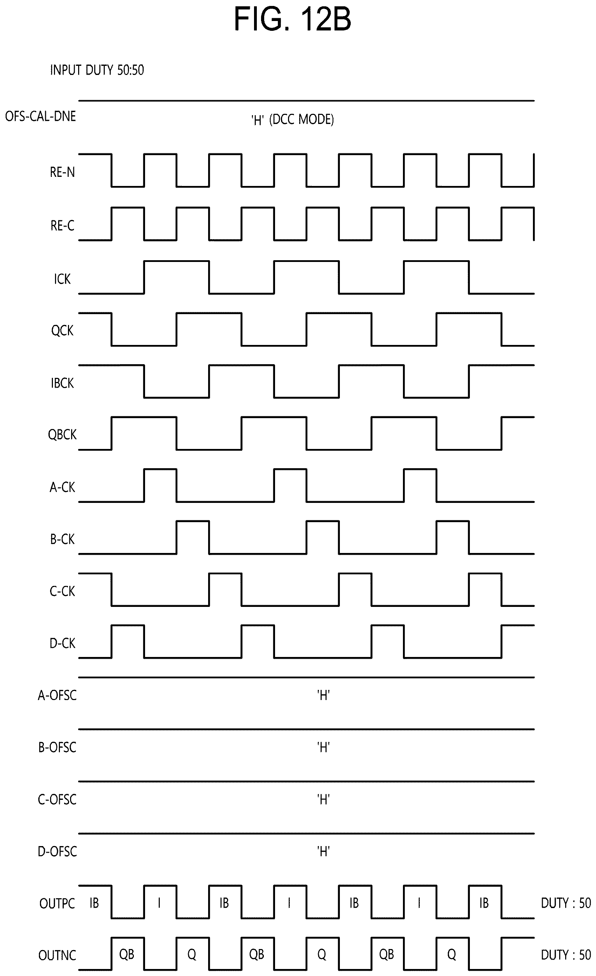

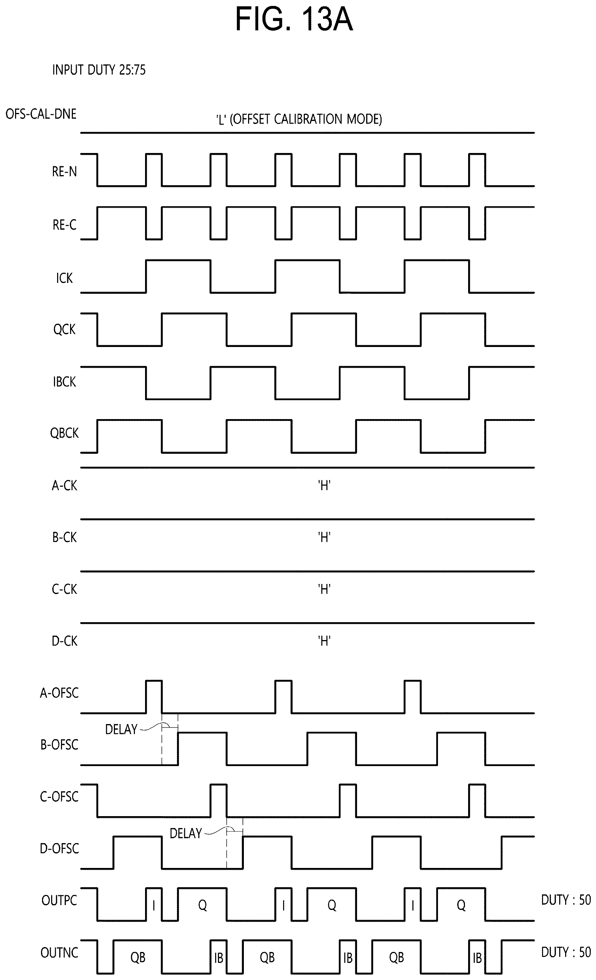

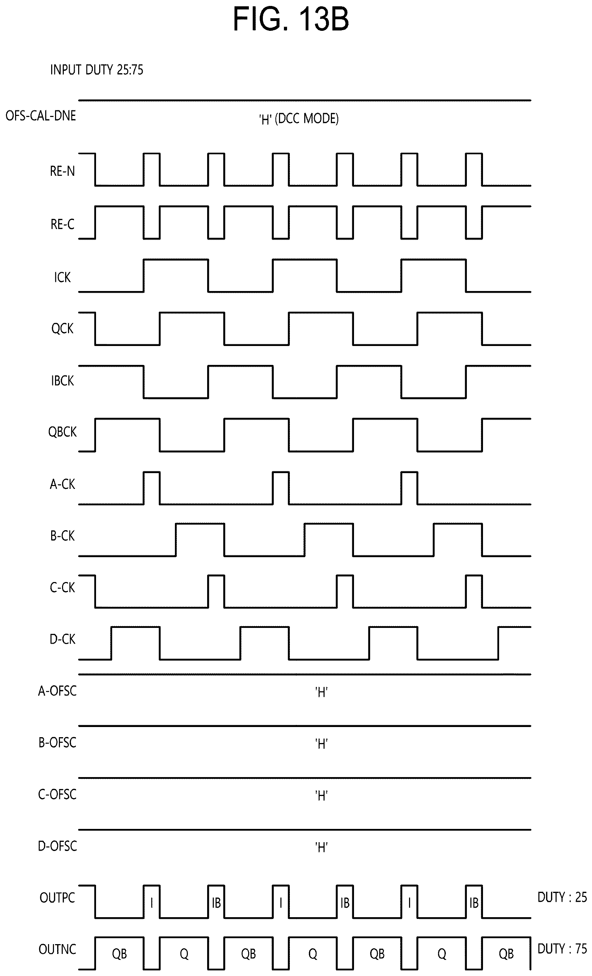

FIG. 12A, FIG. 12B, FIG. 13A, and FIG. 13B are timing diagrams illustrating timing of duty detection operations according to an embodiment of the present disclosure.

FIG. 12A is a timing diagram illustrating a duty detection operation during an offset adjustment interval when input signals, including the second external clock signal RE-N and the first external clock signal RE-C, are input with a duty cycle of 50:50.

Referring to FIG. 12A, when the duty cycle correction circuit 500 initiates an operation during the offset adjustment interval, the offset calibration complete signal OFS-CAL-DNE is maintained at a logic low level until offset adjustment is completed.

Because the offset calibration complete signal OFS-CAL-DNE is at a logic low level, the plurality of normal preliminary signals A-CK, B-CK, C-CK, and D-CK are each output at a logic high level.

The first offset preliminary signal A-OFSC has a pulse width corresponding to a phase difference between a rising edge of the first phase clock signal ICK and a rising edge of the second phase clock signal QCK. The second offset preliminary signal B-OFSC has a pulse width corresponding to a phase difference between a rising edge of the second phase clock signal QCK and a rising edge of the third phase clock signal IBCK and is generated at a time delayed by a time period corresponding to the delay of the first delay circuit 641 of FIG. 11. The third offset preliminary signal C-OFSC have a pulse width corresponding to a phase difference between a rising edge of the third phase clock signal IBCK and a rising edge of the fourth phase clock signal QBCK. The fourth offset preliminary signal D-OFSC has a pulse width corresponding to a phase difference between a rising edge of the fourth phase clock signal QBCK and a rising edge of the first phase clock signal ICK and is generated at a time delayed by a time period corresponding to the delay of the second delay circuit 642 of FIG. 11.

The first offset adjustment reference signal OUTPC is generated by logically combining the first offset preliminary signal A-OFSC and the second offset preliminary signal B-OFSC, and the second offset adjustment reference signal OUTNC is generated by logically combining the third offset preliminary signal C-OFSC and the fourth offset preliminary signal D-OFSC.

The first offset adjustment reference signal OUTPC, which is generated by logically combining the first offset preliminary signal A-OFSC and the second offset preliminary signal B-OFSC, has a signal component I of the first phase clock signal ICK and a signal component Q of the second phase clock signal QCK that are alternately repeated. Because the signal components I and Q are combined, the first offset adjustment reference signal OUTPC has a duty cycle of 50:50 regardless of the duty cycle of the multiphase clock signals ICK, QCK, IBCK, and QBCK. By delaying the second offset preliminary signal B-OFSC such that the signal components I and Q do not overlap, a sufficient timing margin may be generated from the first offset adjustment reference signal OUTPC with a duty cycle of 50:50.

The second offset adjustment reference signal OUTNC, which is generated by logically combining the third offset preliminary signal C-OFSC and the fourth offset preliminary signal D-OFSC, has a signal component IB of the third phase clock signal IBCK and a signal component QB of the fourth phase clock signal QBCK are alternately repeated. Because the signal components IB and QB are combined, the second offset adjustment reference signal OUTNC has a duty cycle of 50:50 regardless of the duty cycle of the multiphase clock signals ICK, QCK, IBCK, and QBCK. By delaying the fourth offset preliminary signal D-OFSC such that the signal components IB and QB do not overlap, a sufficient timing margin may be generated from the second offset adjustment reference signal OUTNC with a duty cycle of 50:50.

Offset compensation is performed under control of the duty control circuit 520 as described with reference to FIG. 8, based on the plurality of offset adjustment reference signals OUTPC and OUTNC. As described, because the plurality of offset adjustment reference signals OUTPC and OUTNC have a duty cycle of 50:50 regardless of the duty cycle of the input signals, including the plurality of external clock signals RE-C and RE-N, the offset of the duty detection circuit 510 may be accurately compensated or adjusted based on the offset adjustment reference signals.

FIG. 12B is a timing diagram illustrating a duty detection operation during a duty cycle adjustment interval when the input signals, including the second external clock signal RE-N and the first external clock signal RE-C, are input with a duty cycle of 50:50.

Because the offset adjustment is completed during the offset adjustment interval described with reference to FIG. 12A, the offset calibration complete signal OFS-CAL-DNE transitions to a logic high level.

Because the offset calibration complete signal OFS-CAL-DNE is at a logic high level, the plurality of offset preliminary signals A-OFSC, B-OFSC, C-OFSC, and D-OFSC are each output at a logic high level.

The first normal preliminary signal A-CK has a pulse width corresponding to a phase difference between a rising edge of the first phase clock signal ICK and a rising edge of the second phase clock signal QCK. The second normal preliminary signal B-CK has a pulse width corresponding to a phase difference between a rising edge of the second phase clock signal QCK and a rising edge of the third phase clock signal IBCK. The third normal preliminary signal C-CK has a pulse width corresponding to a phase difference between a rising edge of the third phase clock signal IBCK and a rising edge of the fourth phase clock signal QBCK. The fourth normal preliminary signal D-CK has a pulse width corresponding to a phase difference between a rising edge of the fourth phase clock signal QBCK and a rising edge of the first phase clock signal ICK.

During the duty cycle adjustment interval, unlike the offset adjustment interval, the first offset adjustment reference signal OUTPC is generated by logically combining the first normal preliminary signal A-CK and the third normal preliminary signal C-CK, and the second offset adjustment reference signal OUTNC is generated by logically combining the second normal preliminary signal B-CK and the fourth normal preliminary signal D-CK.

Because the first offset adjustment reference signal OUTPC is generated by logically combining the first normal preliminary signal A-CK and the third normal preliminary signal C-CK, the signal component I of the first phase clock signal ICK and the signal component IB of the third phase clock signal IBCK are alternately repeated in the first offset adjustment reference signal OUTPC.

Because the second offset adjustment reference signal OUTNC is generated by logically combining the second normal preliminary signal B-CK and the fourth normal preliminary signal D-CK, the signal component Q of the second phase clock signal QCK and the signal component QB of the fourth phase clock signal QBCK are alternately repeated in the first offset adjustment reference signal OUTNC.

Because the offset is compensated or adjusted during the offset adjustment interval, the first offset adjustment reference signal OUTPC and the second offset adjustment reference signal OUTNC have a duty cycle of 50:50, the same as the input signals.

The duty control circuit 520 performs a duty cycle adjustment operation by controlling the duty adjustment circuit 101 and the duty detection circuit 510 based on the plurality of duty detection signals DCD-OUTP and DCD-OUTN generated in accordance with the first offset adjustment reference signal OUTPC and the second offset adjustment reference signal OUTNC.

FIG. 13A is a timing diagram illustrating a duty detection operation during an offset adjustment interval when the input signals, including the second external clock signal RE-N and the first external clock signal RE-C, are input with a duty cycle of 25:75.

Referring to FIG. 13A, when the duty cycle correction circuit 500 starts operating during the offset adjustment interval, the offset calibration complete signal OFS-CAL-DNE is maintained at a logic low level until offset adjustment is completed.

Because the offset calibration complete signal OFS-CAL-DNE is at a logic low level, the plurality of normal preliminary signals A-CK, B-CK, C-CK, and D-CK are each output at a logic high level.

The first offset adjustment reference signal OUTPC is generated by logically combining the first offset preliminary signal A-OFSC and the second offset preliminary signal B-OFSC, and the second offset adjustment reference signal OUTNC is generated by logically combining the third offset preliminary signal C-OFSC and the fourth offset preliminary signal D-OFSC.

Because the first offset adjustment reference signal OUTPC is generated by logically combining the first offset preliminary signal A-OFSC and the second offset preliminary signal B-OFSC, the signal component I of the first phase clock signal ICK and the signal component Q of the second phase clock signal QCK are alternately repeated. Because the signal components I and Q are combined, the first offset adjustment reference signal OUTPC has a duty cycle of 50:50 regardless of the duty cycle of the multiphase clock signals ICK, QCK, IBCK, and QBCK. By delaying the second offset preliminary signal B-OFSC such that the signal components I and Q do not overlap, a sufficient timing margin may be generated from the first offset adjustment reference signal OUTPC with a duty cycle of 50:50.

Because the second offset adjustment reference signal OUTNC is generated by logically combining the third offset preliminary signal C-OFSC and the fourth offset preliminary signal D-OFSC, the signal component IB of the third phase clock signal IBCK and the signal component QB of the fourth phase clock signal QBCK are alternately repeated. Because the signal components IB and QB are combined, the second offset adjustment reference signal OUTNC has a duty cycle of 50:50 regardless of the duty cycle of the multiphase clock signals ICK, QCK, IBCK, and QBCK. By delaying the fourth offset preliminary signal D-OFSC such that the signal components IB and QB do not overlap, a sufficient timing margin may be generated from the second offset adjustment reference signal OUTNC with a duty cycle of 50:50.

Offset compensation is performed under control of the duty control circuit 520 as described with reference to FIG. 8, based on the plurality of offset adjustment reference signals OUTPC and OUTNC. As described, because the plurality of offset adjustment reference signals OUTPC and OUTNC has a duty cycle of 50:50 regardless of the duty cycle of the input signals, including the plurality of external clock signals RE-C and RE-N, the offset of the duty detection circuit 510 may be accurately compensated or adjusted based on the offset adjustment reference signals.

FIG. 13B is a timing diagram illustrating a duty detection operation during a duty cycle adjustment interval when the input signals, including the second external clock signal RE-N and the first external clock signal RE-C, are input with a duty cycle of 25:75.

Because the offset adjustment is completed during the offset adjustment interval described with reference to FIG. 13A, the offset calibration complete signal OFS-CAL-DNE transitions to a logic high level.

Because the offset calibration complete signal OFS-CAL-DNE is at a logic high level, the plurality of offset preliminary signals A-OFSC, B-OFSC, C-OFSC, and D-OFSC are each output at a logic high level.

The first offset adjustment reference signal OUTPC is generated by logically combining the first normal preliminary signal A-CK and the third normal preliminary signal C-CK, and the second offset adjustment reference signal OUTNC is generated by logically combining the second normal preliminary signal B-CK and the fourth normal preliminary signal D-CK.

Because the first offset adjustment reference signal OUTPC is generated by logically combining the first normal preliminary signal A-CK and the third normal preliminary signal C-CK, the signal component I of the first phase clock signal ICK and the signal component IB of the third phase clock signal IBCK are alternately repeated.

Because the second offset adjustment reference signal OUTNC is generated by logically combining the second normal preliminary signal B-CK and the fourth normal preliminary signal D-CK, the signal component Q of the second phase clock signal QCK and the signal component QB of the fourth phase clock signal QBCK are alternately repeated.

Because the offset is compensated or adjusted during the offset adjustment interval, the first offset adjustment reference signal OUTPC and the second offset adjustment reference signal OUTNC have a duty cycle of 25:75, the same as the input signals.

The duty control circuit 520 performs a duty cycle adjustment operation by controlling the duty adjustment circuit 101 and the duty detection circuit 510 based on the plurality of duty detection signals DCD-OUTP and DCD-OUTN generated in accordance with the first offset adjustment reference signal OUTPC and the second offset adjustment reference signal OUTNC.

Concepts are disclosed in conjunction with examples and embodiments. Those skilled in the art will understand that various modifications, additions, combinations, and substitutions are possible without departing from the scope and technical concepts of the present disclosure. The embodiments disclosed in the present specification should be considered from an illustrative standpoint and not a restrictive standpoint. Therefore, the scope of the present disclosure is not limited to the provided descriptions. All changes within the meaning and range of equivalency of the claims are included within their scope.

## Claims

1. A duty cycle correction circuit comprising:
a duty adjustment circuit configured to adjust a phase of each of a plurality of external clock signals according to a plurality of duty control codes to generate a plurality of duty correction clock signals;
a phase dividing circuit configured to divide phases of the plurality of duty correction clock signals to generate a plurality of multiphase clock signals; and
a duty detection circuit configured to, during an offset adjustment interval, adjust an offset decision bit among a plurality of offset control codes and determine whether offset compensation is performed based on a phase difference between the plurality of multiphase clock signals, and when the offset compensation is performed, to adjust offset adjustment bits among the plurality of offset control codes.

2. The duty cycle correction circuit of claim 1, wherein the duty detection circuit comprises:
a phase mixing circuit configured to mix the plurality of multiphase clock signals according to a predetermined combination to generate a plurality of duty signals;
a duty voltage conversion circuit configured to adjust a current according to the plurality of duty signals to generate a plurality of duty voltage signals;
a comparison circuit configured to compare phases of the plurality of duty voltage signals to generate a plurality of duty detection signals; and
an offset compensation circuit coupled to an output terminal of the comparison circuit and configured to vary a capacitance applied to the output terminal of the comparison circuit according to the plurality of offset control codes.

3. A duty cycle correction circuit comprising:
a duty adjustment circuit configured to adjust a phase of each of a plurality of external clock signals according to a plurality of duty control codes to generate a plurality of duty correction clock signals;
a phase dividing circuit configured to divide phases of the plurality of duty correction clock signals to generate a plurality of multiphase clock signals; and
a duty detection circuit configured to generate a plurality of offset adjustment reference signals having a target duty cycle regardless of a duty cycle of the plurality of multiphase clock signals by using the a plurality of multiphase clock signals, configured to, during an offset adjustment interval, adjust an offset decision bit among a plurality of offset control codes and determine whether offset compensation is performed based on a phase difference between the plurality of offset adjustment reference signals, and when the offset compensation is performed, to adjust offset adjustment bits among the plurality of offset control codes.

4. The duty cycle correction circuit of at least one of claims 1 and 3, wherein the duty detection circuit is configured to detect a phase difference of the plurality of offset adjustment reference signals according to a plurality of control signals based on the plurality of offset control codes to generate a plurality of duty detection signals.

5. The duty cycle correction circuit of claim 4, further comprising a duty control circuit configured to generate the plurality of control signals and the plurality of duty control codes according to the plurality of duty detection signals.

6. The duty cycle correction circuit of at least one of claims 1 and 3, wherein the duty detection circuit comprises an offset compensation circuit coupled to an output terminal of the duty detection circuit and configured to vary a capacitance applied to an output terminal of a comparison circuit according to the plurality of offset control codes.

7. The duty cycle correction circuit of at least one of claims 1 and 3, wherein the duty detection circuit comprises:
a first capacitance circuit coupled to a first output terminal of the duty detection circuit and configured to apply a first capacitance to the first output terminal according to a first offset decision bit of a first offset control code among the plurality of offset control codes; and
a first variable capacitance circuit coupled in parallel with the first capacitance circuit to the first output terminal and configured to apply a second capacitance to the first output terminal according to first offset adjustment bits of the first offset control code,
wherein the second capacitance is varied within a range from X to X*n, where X is a first value and n is a natural number, and the value of the first capacitance is equal to half of the first value of the second capacitance.

8. The duty cycle correction circuit of claim 7, wherein the duty detection circuit further comprises:
a second capacitance circuit coupled to a second output terminal of the duty detection circuit and configured to apply a third capacitance to the second output terminal according to a second offset decision bit of a second offset control code among the plurality of offset control codes; and
a second variable capacitance circuit coupled in parallel with the second capacitance circuit to the second output terminal and configured to apply a fourth capacitance to the second output terminal according to second offset adjustment bits of the second offset control code;
wherein the fourth capacitance is varied within a range from Y to Y*n, where Y is a second value and n is a natural number, and the value of the third capacitance is equal to half of the second value of the fourth capacitance.

9. The duty cycle correction circuit of claim 3, wherein the duty detection circuit comprises an offset adjustment reference signal generation circuit configured to generate the plurality of offset adjustment reference signals by combining the plurality of multiphase clock signals differently during each of an offset adjustment interval and a duty cycle adjustment interval.

10. The duty cycle correction circuit of claim 9, wherein the offset adjustment reference signal generation circuit is configured to:
during the duty cycle adjustment interval, generate a first offset adjustment reference signal among the plurality of offset adjustment reference signals by combining a first normal preliminary signal generated based on a first phase clock signal among the plurality of multiphase clock signals and a third normal preliminary signal generated based on a third phase clock signal among the plurality of multiphase clock signals, and generate a second offset adjustment reference signal among the plurality of offset adjustment reference signals by combining a second normal preliminary signal generated based on a second phase clock signal among the a plurality of multiphase clock signals and a fourth normal preliminary signal generated based on a fourth phase clock signal among the a plurality of multiphase clock signals; and
during the offset adjustment interval, generate the first offset adjustment reference signal by combining a first offset preliminary signal generated based on the first phase clock signal and a second offset preliminary signal generated based on the second phase clock signal, and generate the second offset adjustment reference signal by combining a third offset preliminary signal generated based on the third phase clock signal and a fourth offset preliminary signal generated based on the fourth phase clock signal.

11. The duty cycle correction circuit of claim 9, wherein the duty detection circuit further comprises:
a duty voltage conversion circuit configured to adjust a current according to the plurality of offset adjustment reference signals to generate a plurality of duty voltage signals;
a comparison circuit configured to compare phases of the plurality of duty voltage signals to generate a plurality of duty detection signals; and
an offset compensation circuit coupled to an output terminal of the comparison circuit and configured to vary a capacitance applied to the output terminal of the comparison circuit according to the plurality of offset control codes.

12. A duty cycle correction circuit comprising:
a duty detection circuit configured to detect a phase difference between a plurality of multiphase clock signals according to a plurality of control signals including a first offset control code and a second offset control code and to generate a first duty detection signal and a second duty detection signal; and
a duty control circuit configured to generate the plurality of control signals according to the first duty detection signal and the second duty detection signal,
wherein the duty detection circuit comprises an offset compensation circuit configured to apply a first capacitance to a first output terminal outputting the first duty detection signal according to a first offset decision bit of the first offset control code, apply a second capacitance to the first output terminal according to first offset adjustment bits of the first offset control code, apply a third capacitance to a second output terminal outputting the second duty detection signal according to a second offset decision bit of the second offset control code, and apply a fourth capacitance to the second output terminal according to second offset adjustment bits of the second offset control code,
wherein the duty control circuit is configured to, during an offset adjustment interval, determine whether offset compensation is performed by comparing a value of the first duty detection signal obtained by adjusting the first offset control code by 0.5 step and a value of the first duty detection signal obtained by adjusting the second offset control code by 0.5 step, and when the offset compensation is performed, to perform a process including adjusting one of the first offset control code and the second offset control code by 1 step to compensate for an offset.

13. The duty cycle correction circuit of claim 12, wherein the duty control circuit is configured to control the first offset decision bit such that the first capacitance is applied to the first output terminal to adjust the first offset control code by 0.5 step.

14. The duty cycle correction circuit of claim 13, wherein the duty control circuit is configured to control the second offset decision bit such that the third capacitance is applied to the second output terminal to adjust the second offset control code by 0.5 step.

15. The duty cycle correction circuit of claim 12, wherein the duty control circuit is configured to determine that the offset compensation is performed when the value of the first duty detection signal obtained by adjusting the first offset control code by 0.5 step and the value of the first duty detection signal obtained by adjusting the second offset control code by 0.5 step are the same.

16. The duty cycle correction circuit of claim 12, wherein the duty control circuit is configured to adjust the first offset control code by 1 step by applying the second capacitance to the first output terminal according to the first offset adjustment bits.

17. The duty cycle correction circuit of claim 12, wherein the duty detection circuit comprises:
an offset adjustment reference signal generation circuit configured to generate a plurality of offset adjustment reference signals having a target duty cycle regardless of a duty cycle of the plurality of multiphase clock signals by combining the a plurality of multiphase clock signals differently during the offset adjustment interval than in a duty cycle adjustment interval;
a duty voltage conversion circuit configured to adjust a current according to the plurality of offset adjustment reference signals to generate a plurality of duty voltage signals; and
a comparison circuit configured to compare phases of the plurality of duty voltage signals to generate the first duty detection signal and the second duty detection signal.
